# EUROPEAN PATENT APPLICATION

(11) **EP 4 403 943 A1**
(43) Date of publication of application: **24.07.2024**
(21) Application number: 21969324.9
(22) Date of filing: 28.12.2021
(51) Int. Cl.: G01R 31/3835, G01R 31/36, H01M 10/42

(54) **BATTERY LITHIUM PLATING DETECTION METHOD AND APPARATUS, MANAGEMENT SYSTEM, BATTERY AND ELECTRIC APPARATUS**

(71) Applicant: Contemporary Amperex Technology Co., Limited, Ningde, Fujian 352100 (CN)
(72) Inventor: XIE, Lan, Ningde, Fujian 352100 (CN); LIN, Zhen, Ningde, Fujian 352100 (CN); XU, Guangyu, Ningde, Fujian 352100 (CN); YANG, Xinfeng, Ningde, Fujian 352100 (CN)
(74) Representative: Laufhütte, Dieter
(86) International application number: PCT/CN2021/142024
(87) International publication number: WO 2023/122943

(57) **Abstract**

The embodiments of the present disclosure relate to the field of battery technology, and provide a battery lithium plating detection method, device, management system, battery and electric device. The lithium plating detection method includes: charging a to-be-tested battery and stopping charging after the to-be-tested battery has been charged to a first state of charge (SOC), and allowing the to-be-tested battery to rest; obtaining a first voltage of the to-be-tested battery upon completion of electrochemical equilibrium; collecting a second voltage of the to-be-tested battery; and determining that lithium plating has occurred in the to-be-tested battery in case where a difference between the second voltage and the first voltage is greater than a first voltage threshold. By means of the above, it is possible to detect whether lithium plating has occurred in a battery, and the detection efficiency is high, such that long-time lithium plating may be avoided from forming lithium dendrite to pierce the separator and result in short circuit and thermal runaway of the battery, and improve battery safety.

## Description

### TECHNICAL FIELD

The present disclosure relates to the field of battery technology, and more particularly, relates to a battery lithium plating detection method, device, management system, battery and electric device.

### BACKGROUND

With the wide application of lithium-ion batteries in new energy vehicles, energy storage and other fields, higher request has been put forward to the charging speed of lithium-ion batteries.

An increasing battery charging speed will lead to an increasing battery charging rate, while an increased battery rate results in an increased battery polarization, serious accumulation of lithium ions on the cathode surface and a significantly reduced anode potential during charging process, which might be closer to the 0V lithium plating potential, and the risk of lithium plating is greatly increased during the charging process. After lithium plating takes place on a cathode, the formed lithium dendrites may react with the electrolyte to produce locally a lot of heat, or pierce the battery separator to result in a short circuit between the anode and the cathode, and even result in a battery fire and explosion. This is an important factor threatening the safety of battery use today and in the future. Therefore, it is an urgent technical problem to be solved how to detect whether lithium plating has occurred in a battery, so as to prevent serious lithium plating from taking place and avoid the lithium dendrites from further growing and piercing the separator.

### SUMMARY

In view of the above problems, the embodiments of this disclosure provide a battery lithium plating detection method, device, management system, battery and electric device, which may prevent the battery from overcharging and improve the safety performance of the battery.

According to a first aspect of the embodiments of this disclosure, a lithium plating detection method is provided, and the method includes: charging a to-be-tested battery and stopping charging after the to-be-tested battery has been charged to a first state of charge (SOC), and allowing the to-be-tested battery to rest; obtaining a first voltage of the to-be-tested battery upon completion of electrochemical equilibrium; collecting a second voltage of the to-be-tested battery; and determining that lithium plating has occurred in the to-be-tested battery in case where a difference between the second voltage and the first voltage is greater than a first voltage threshold.

The embodiments of this disclosure obtain the first voltage of the battery upon completion of electrochemical equilibrium by first charging the battery to the specific SOC and allowing the battery to rest. Then, the second voltage of the battery is collected. In case where the difference between the second voltage and the first voltage is greater than the first voltage threshold value, it can be determined that lithium plating has occurred in the battery. The detection has high efficiency, and may avoid long-time lithium plating from forming lithium dendrite to piece the separator and result in short circuit and thermal runaway of the battery, and improve battery safety.

In some embodiment, the first SOC meets a first SOC range or a second SOC threshold range, wherein the first SOC threshold range is 5%-30% and the second SOC threshold range is 50%-60%.

By setting the first SOC threshold range to be 5%-30% and the second SOC threshold range to be 50%∼60%, it is possible to realize a relatively accurate and timely detection of battery lithium plating.

In some embodiment, the first voltage threshold ranges from 5~30 millivolts (mV).

The value range 5 to 30mV of the first voltage threshold is set according to the voltage acquisition accuracy of the BMS, which may match the voltage acquisition accuracy of the BMS to avoid incorrect determination that lithium plating has occurred in to-be-tested battery.

In some embodiments, the first voltage threshold is 5mV.

By setting the first voltage threshold to be 5mV, not only the voltage acquisition accuracy of the BMS may be matched, so as to avoid the incorrect determination that lithium plating has occurred in the to-be-tested battery, but also detection requirements for most batteries may be satisfied, and the applicability is improved.

In some embodiment, said obtaining a first voltage of the to-be-tested battery upon completion of electrochemical equilibrium includes: collecting, in a first time interval, voltage of the to-be-tested battery at a first preset frequency; and determining that the to-be-tested battery has completed electrochemical equilibrium in case where a difference between two collected consecutive voltages is less than a second voltage threshold, and identifying a voltage at end of the two consecutive voltages as the first voltage.

By collecting the voltage of the to-be-tested battery in the first time interval, determining that the to-be-tested battery has completed the electrochemical equilibrium in case where the difference between two collected consecutive voltages is less than the second voltage threshold, and thereby identifying the first voltage, the embodiments of this disclosure may make a relatively accurate determination that the to-be-tested battery has completed the electrochemical equilibrium, so as to improve the accuracy of the obtained first voltage. By collecting the voltage of the to-be-tested battery at the first preset frequency, the detection of the first voltage may be made more timely.

In some embodiment, the second voltage threshold ranges from 1∼5mV.

By setting the range of the second voltage threshold as 1~5mV, it is possible to make a relatively accurate determination on whether the to-be-tested battery has completed the electrochemical equilibrium.

In some embodiments, the second voltage threshold is 5mV.

By setting the second voltage threshold as 5mV, not only the voltage acquisition accuracy of the BMS may be matched, so as to avoid incorrect determination that lithium plating has occurred in the to-be-tested battery, but also detection requirements for most batteries may be satisfied, and the applicability is improved.

In some embodiment, said collecting a second voltage of the to-be-tested battery includes: collecting, in a second time interval, the second voltage of the to-be-tested battery at a second preset frequency.

The above may improve the accuracy of the detection results, and avoid failing to detect lithium plating. By collecting the second voltage of the to-be-tested battery at the second preset frequency, the detection of lithium plating may be made more timely.

In some embodiments, the second time interval is greater than 5min.

By setting the second time interval to be greater than or equal to 5min, not only the accuracy of the detection results may be improved, so as to avoid failing to detect lithium plating, but also the detection requirements for most batteries may be satisfied, and the applicability may be improved.

In some embodiments, after said determining that lithium plating has occurred in the to-be-tested battery in case where a difference between the second voltage and the first voltage is greater than a first voltage threshold, the method further includes: generating an early warning message, which is used for indicating that lithium plating has occurred in the to-be-tested battery.

After determining that lithium plating has occurred in the to-be-tested battery, the warning message is prompted to indicate the existence of lithium plating in the to-be-tested battery, so that the operator may process correspondingly. This further avoids long-time lithium plating from forming lithium dendrite to piece the separator and result in battery short circuit and thermal control, and further improves the battery safety.

According to a second aspect of the embodiments of this disclosure, a battery lithium plating detection device is provided. The device includes: a charging module for charging a to-be-tested battery and stopping charging after the to-be-tested battery has been charged to a first state of charge (SOC), and allowing the to-be-tested battery to rest; an obtaining module for obtaining a first voltage of the to-be-tested battery upon completion of electrochemical equilibrium; a collection module for collecting a second voltage of the to-be-tested battery; and a determination module for determining that lithium plating has occurred in the to-be-tested battery in case where a difference between the second voltage and the first voltage is greater than a first voltage threshold.

According to a third aspect of the embodiments of this disclosure, a battery management system is provided. The system includes: at least one processor; and a memory communicatively connected with the at least one processor; where the memory stores instructions executable by the at least one processor, and the instructions are executed by the at least one processor to enable the battery management system to implement steps of the above battery lithium plating detection method.

According to a fourth aspect of the embodiments of this disclosure, a battery is provided. The battery includes the above battery management system.

According to a fifth aspect of the embodiments of this disclosure, an electric device is provided. The electric device includes the above battery, and the battery is for supplying electric energy.

The above description is only a summary of the technical solutions of this disclosure. In order to better understand the technical means of this disclosure, so as to implement according to the content of the specification, and in order to make the above and other purposes, features and advantages of this disclosure more apparent, some specific embodiments of this disclosure are provided below.

### BRIEF DESCRIPTION OF THE DRAWINGS

The features, advantages and technical effects of the exemplary embodiments of this disclosure are described below with reference to the accompanying drawings.
FIG. 1 is a schematic flow chart of a battery lithium plating detection method provided in some embodiments of this disclosure;
FIG. 2 is a schematic diagram of a battery voltage vs. SOC;
FIG. 3 is a schematic diagram of a full battery voltage vs. time for batteries with lithium plating and without lithium plating after being charged to a specific SOC and allowed to rest;
FIG. 4 is a flow chart for illustrating the S 120 in FIG. 1;
FIG. 5 is a flow chart for illustrating the S 130 in FIG. 1;
FIG. 6 is a schematic flow chart of a battery lithium plating detection method provided in some embodiments of this disclosure;
FIG. 7 is a schematic flow chart of lithium battery lithium plating detection method for electric vehicles provided in some embodiments of this disclosure;
FIG. 8 is a schematic structural diagram of a battery lithium plating detection device provided in some embodiments of this disclosure;
FIG. 9 is a schematic structural diagram of a battery management system provided in some embodiments of this disclosure;
FIG. 10 is a schematic structural diagram of a battery provided in some embodiments of this disclosure;
FIG. 11 is a schematic structural diagram of an electric device provided in some embodiments of this disclosure.

### DETAILED DESCRIPTION OF THE EMBODIMENTS

In order to make the objects, technical solutions and advantages of the embodiments of the present disclosure clearer, the technical solutions in the embodiments of the present disclosure will be clearly and completely described below with reference to accompanying drawings in the embodiments of the present disclosure. Obviously, the described embodiments are merely some of, rather than all of, the embodiments of the present disclosure. All the other embodiments obtained by those skilled in the art based on the embodiments specified in the present disclosure without involving any creative effort shall fall within the scope of protection of the present disclosure.

Unless otherwise defined, all technical and scientific terms used in the present disclosure have the same meanings as those commonly understood by those skilled in the art of the present disclosure. The terms used in the specification of the present disclosure are merely for the purpose of describing specific embodiments, but are not intended to limit the present disclosure. The terms "comprise" and "have" and their variants in the specification, the claims and the above brief description of the drawings of the present disclosure are intended to cover non-exclusive inclusion. The terms "first", "second" and the like in the specification, the claims and the above brief description of the drawings of the present disclosure are used to distinguish different objects, rather than to describe a specific order or primary-secondary relationship. In the description of the present disclosure, the meaning of "a plurality of" is two or more, unless otherwise indicated.

The phrase "embodiments" referred to in the present disclosure means that the specific features, structures, and characteristics described in combination with the embodiments are included in at least one embodiment of the present disclosure. The phrase at various locations in the specification does not necessarily refer to the same embodiment, or an independent or alternative embodiment exclusive of another embodiment. Those skilled in the art understand, in explicit and implicit manners, that an embodiment described in the present disclosure may be combined with another embodiment.

As mentioned above, it should be emphasized that when the term "comprise/include" is used in this specification, it is used to clearly indicate the presence of stated features, integers, steps or assemblies, but does not preclude the presence or addition of one or more other features, integers, steps, components or groups thereof. As used in the present disclosure, the singular forms "a", "an" and "the" also include plural forms, unless otherwise clearly indicated in the context.

The terms "a" and "an" in this specification may indicate one, but may also be consistent with the meaning of "at least one" or "one or more". The term "about" generally means the mentioned value plus or minus 10%, or more specifically plus or minus 5%. The term "or" used in the claims means "and/or" unless it is clearly stated that it only refers to an alternative solution.

In the present disclosure, the term "and/or" is merely an association relation describing associated objects, which means that there may be three relations, for example, A and/or B may represent three situations: A exists alone, both A and B exist, and B exists alone. In addition, the character "/" in the present disclosure generally indicates that the associated objects before and after the character are in an "or" relation.

A battery mentioned in this field may be grouped into primary battery and rechargeable battery according to whether it is rechargeable. Primary battery is commonly known as "disposable" battery and galvanic cell, because it cannot be recharged and has to be discarded after its power is exhausted. Rechargeable battery is also called secondary battery, secondary cell or storage battery. Manufacturing material and process of the rechargeable battery is different from the primary battery. The rechargeable battery has the advantages that it can be recycled multiple times after being charged, and the output current load capacity of the rechargeable battery is higher than that of most primary batteries. At present, the common types of rechargeable battery are: lead-acid battery, nickel-metal hydride battery and lithium-ion battery. The lithium-ion battery has the advantages of having a light weight, a large capacity (the capacity is 1.5 to 2 times that of the nickel-metal hydride battery of the same weight), no memory effect, etc., and has a very low self-discharge rate, so it is still widely used even if the price thereof is relatively high. The battery described in the embodiments of the present disclosure refers to a rechargeable battery.

The battery mentioned in the embodiments of the present disclosure refers to a single physical module including one or more battery cells to provide a higher voltage and capacity. For example, the battery mentioned in the present disclosure may include a battery module or a battery pack, etc. The battery cell mentioned in the embodiments disclosed in the present application can be directly or indirectly applied to an appropriate device to power the device. The battery cell includes an anode electrode sheet, a cathode electrode sheet, electrolyte and a separator, and is the basic structural unit composing a battery module and a battery pack. Common anode electrode materials used for the lithium-ion battery include lithium cobalt oxide, lithium manganate oxide, lithium nickelate, lithium iron phosphate, and ternary materials (such as lithium nickel manganate cobalt oxide), etc. Common cathode electrode materials include carbon materials (such as graphite) and silicon-based materials, etc. Common separator materials include Polyolefin materials which are mainly polyethylene (PE) or polypropylene (PP). Battery cells are generally grouped into three types according to their packaging: cylindrical battery cell, prismatic battery cell and pouch battery cell.

A plurality of battery cells may be connected in series and/or in parallel through their electrode terminals for various application scenarios. In some high-power application scenarios such as electric vehicles, the application of the battery includes three levels: battery cell, battery module and battery pack. The battery module is formed by electrically connecting a certain number of battery cells together and putting them into a frame to protect the battery cells from external impact, heat, vibration, etc. The battery pack is the final state of a battery system installed into the electric vehicle. Most of the current battery packs are made by assembling various control and protection systems such as a battery management system (BMS) and a thermal management component on one or more battery modules. With the development of technology in the field of battery, the level of battery module can be omitted. That is, the battery pack may be directly formed from battery cells. This improvement allows the battery system to increase the gravimetric energy density and the volumetric energy density while significantly reducing the number of parts. The battery mentioned in the present disclosure includes a battery module or a battery pack.

In recent years lithium-ion batteries have been widely used in computers, mobile phones and other electronic devices and in the power battery system of new energy vehicles due to their advantages of high energy density, high power density, long service life and being environmentally friendly. With the wide application of lithium-ion batteries in electric vehicles, energy storage and other fields, higher request has been brought forward to battery charging speed. Compared with traditional fuel vehicles, the most distinct disadvantage of electric vehicles is the charging time. And it is requested to increase the charging speed of electric vehicles as much as possible and shorten the time required for charging. Fast charging is an effective way to shorten the charging time, which is the key to improve the user experience of electric vehicles.

Fast charging may significantly reduce charging time and ease range anxiety. However, fast charging requires increasing battery charging rate, which often results in side effects of batteries. Take a lithium-ion battery with graphite cathode system as an example. During the charging process, the battery undergoes electrode polarization, and the electrode potential deviates from the equilibrium potential, where the difference between the polarization potential and the equilibrium potential is overpotential. In case where the cathode overpotential is too low, metallic lithium will be formed on the surface of the cathode. Lithium plating not only reduces the performance of lithium-ion batteries, for example, the cycle life is greatly shortened, but also limits the capacity of lithium-ion batteries capable of rapid charging, resulting in decreased capacity and power of batteries. In the case of serious lithium plating, lithium dendrites would be formed on the cathode surface, and lithium dendrites would likely pierce the separator, resulting in short circuit between the adjacent anode and cathode electrode sheets, causing thermal runaway, and seriously endangering battery safety.

Therefore, it is an urgent technical problem to be solved how to detect whether lithium plating has occurred in a battery, so as to prevent serious lithium plating from taking place and avoid the lithium dendrites from further growing and piercing the separator.

In view of this, the embodiments of the present disclosure provide a battery lithium plating detection method, device, battery management system, battery and electric device. A battery is first charged to a specific battery state of charge (SOC), and allowed to rest, thereby a first voltage of the battery upon completion of electrochemical equilibrium is obtained. Then, a second voltage of the battery is collected. And in case where a difference between the second voltage and the first voltage is greater than a first voltage threshold, it is determined that lithium plating has occurred in the battery. At this time, an early warning may be sent. Through the above method, it is possible to detect whether lithium plating has occurred in a battery, and the detection efficiency is high, such that long-time lithium plating may be avoided from forming lithium dendrite to pierce the separator and result in short circuit and thermal runaway of the battery, and improve battery safety.

It is understood that the battery lithium plating detection method, device, battery management system and battery described in embodiments of this disclosure are applicable to all kinds of electric devices using batteries, especially vehicles. The following embodiments are described with an example of application in a vehicle for the convenience of description.

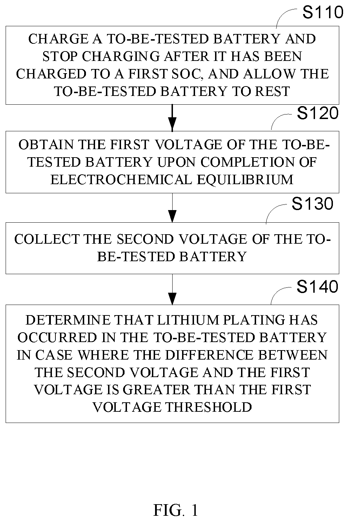

FIG. 1 is a schematic flow chart of a battery lithium plating detection method provided in some embodiments of this disclosure. The battery lithium plating detection method may be applied to a battery in an electric device, and, further, to a BMS of batteries. The following will describe the concept of this disclosure by taking the application of the method to the BMS of batteries in vehicles.

The application scenarios of the battery lithium plating detection method in the embodiments of this disclosure include but are not limited to: lithium plating detection performed by batteries manufacturers, lithium plating detection of batteries of electric vehicles performed by vehicle manufacturers, lithium plating detection of batteries of electric vehicles performed by electric vehicle users, lithium plating detection of batteries of electric vehicles performed by electric vehicle repair plants or detection institutions, etc. It is possible to manually select and perform the battery lithium plating detection of the embodiments of this disclosure, it is also possible to set the battery lithium plating detection of the embodiments of this disclosure as an automatic test procedure of the BMS and automatically perform the same.

The battery lithium plating detection method includes the following steps:

At S 110, charge a to-be-tested battery and stop charging after the to-be-tested battery has been charged to a first SOC, and allow the to-be-tested battery to rest.

The battery lithium plating detection method of the embodiments of this disclosure requires charging the battery to the first SOC first. When the battery lithium plating detection method of the embodiments of this application starts, the to-be-tested battery may be charged automatically or manually by an operator prompted by a sent prompt message.

Start charging the to-be-tested battery, and stop charging when the battery is charged to the set first SOC, and allow the battery to rest. Perform a follow-up step of detecting the voltage of the to-be-tested battery when the battery is rested.

### < Determining the first SOC >

During battery charging, a potential lithium plating occurring on a cathode surface will result in a low potential at the cathode surface and a high potential inside the cathode. The inventors of the present disclosure have found that, a full battery voltage is particularly sensitive to changes in SOC when the battery is charged to a specific SOC. After the battery is charged to the specific SOC, and when the battery is rested (for a rest period of about 5 minutes (min)~2 hours (h)), the lithium on the cathode surface is stripped back into the cathode, the cathode potential decreases overall, and the whole battery potential increases. At this time, it can be determined that lithium plating has occurred in the battery.

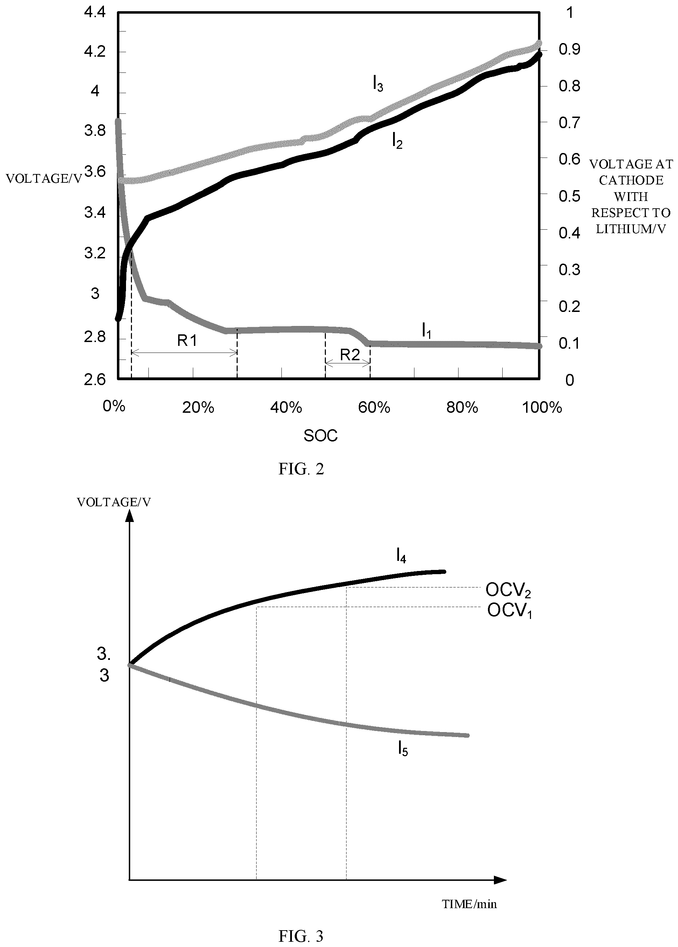

FIG. 2 is a schematic diagram of a battery voltage vs. SOC. As shown in FIG. 2, the curve l₁ in the figure represents an overall cathode voltage, the curve l₂ represents a full battery voltage, and the curve l₃ represents an overall anode voltage, where the sum of the overall cathode voltage and the full battery voltage equals to the overall anode voltage. In FIG. 2, the overall cathode voltage changes significantly with SOC in regions R₁ and R₂ than in other regions. As SOC increases, the slope of the curve l₁ is larger, and the overall cathode voltage drops faster. The specific SOC mentioned above refers to the SOCs in the two regions R₁ and R₂.

FIG. 3 is a schematic diagram of a full battery voltage vs. time for batteries with lithium plating and without lithium plating after being charged to a specific SOC and allowed to rest. A battery with lithium plating is a battery in which lithium plating has occurred, and a battery without lithium plating is a battery in which no lithium plating has occurred. As shown in FIG. 3, l₄ in the figure represents the full battery voltage of the battery with lithium plating, and l₅ represents the full battery voltage of the battery without lithium plating. For the battery with lithium plating when allowed to rest after being charged to the specific SOC, lithium at the cathode surface will be stripped back into the cathode, such that the overall cathode voltage will be decreased and the full battery voltage will be increased, as shown by l₄. And for the battery without lithium plating, the full battery voltage will gradually decrease during the rest period of the battery, as shown by l₅.

Therefore, it is possible to determine the first SOC on the basis of R₁ and R₂. The inventors have found that, R₁ corresponds to a SOC range of about 5%~30%, and R₂ corresponds to a SOC range of about 50%-60%. Therefore, the value of the first SOC is in the SOC range of R₁ and R₂, which may realize a relatively accurate and timely detection of battery lithium plating. In some embodiments, the first SOC may be made to meet a first SOC threshold range or a second SOC threshold range, where the first SOC threshold range is 5%-30% and the second SOC threshold range is 50%-60%. For example, the first SOC may be 5%, 20%, 30%, 50%, 55%, or 60%.

An adjustable range of the first SOC, for example, 5%-30% and 50%∼60%, may be preset for battery lithium plating detection, when applying the battery lithium plating detection method of embodiments of this disclosure. Prior to starting the detection, the operator may select and set the first SOC for the lithium plating detection from the adjustable range of the first SOC, and then start charging and detection.

The operator may select the first SOC according to the current SOC of the battery. When selecting the first SOC, the operator shall ensure that the first SOC is not lower than the current SOC and is generally closest to the current SOC state. By flexibly selecting the first SOC according to the current SOC state, not only the charging efficiency is ensured, but also the state of the battery lithium plating man be timely detected. For example, if the current SOC of the battery is 2%, the operator may set the first SOC to be 5%, 10%, or other value within the adjustable range and greater than the current SOC of the battery. Again, if the current SOC of the battery is 40%, the operator may set the first SOC to be 50%, 55%, or other value within the adjustable range and greater than the current SOC of the battery.

Thus, in some embodiments, prior to S 110, the battery lithium plating detection method may also include:
At S 1, control a display device to display the first SOC threshold range and/or the second SOC threshold range;
At S2, receives from a user his/her selection of the first SOC;
At S3, determine whether the selected first SOC is lower than the current SOC of the battery;
At S4, in case where the first SOC is lower than the current SOC of the battery, output a first prompt message to prompt the user to re-select the first SOC;
At S5, determine whether the selected first SOC is a value closest to the current SOC in the first SOC threshold range and/or in the second SOC threshold range;
At S6, in case where the selected first SOC is not a value closest to the current SOC in the first SOC threshold range and/or in the second SOC threshold range, output a second prompt message to prompt the user to re-select the first SOC.

Through the above steps, the charging efficiency may be guaranteed, and the state of the battery lithium plating may be timely detected.

It is understood that, it is also possible to pre-set the first SOC for battery lithium plating detection to be a fixed value, for example, 50% or 60%. The operator does not need to set the first SOC when performing the detection, and may directly start charging and determination. In this way, the operation is simple and the efficiency is improved.

If the first SOC is greater than the current SOC of the battery, during the detection the to-be-tested battery is first charged to the first SOC, and then rest for a follow-up voltage detection. If the first SOC is less than or equal to the current SOC of the battery, during the detection the to-be-tested battery will not be charged, but rest for a follow-up voltage detection.

At S120, obtain the first voltage of the to-be-tested battery upon completion of electrochemical equilibrium.

In the embodiments of this disclosure, the voltage of the to-be-tested battery is normally its full battery voltage, unless otherwise specified.

The first voltage of the to-be-tested battery, which is the voltage of the to-be-tested battery upon completion of electrochemical equilibrium, is obtained after the to-be-tested battery is allowed to rest. The voltage collected at this time is used as a comparative reference to determine whether the voltage is increased, so as to more objectively and accurately evaluate the increased voltage of the battery due to stripping of the lithium dendrites. If the to-be-tested battery completes electrochemical equilibrium, the first voltage at this time is collected and labeled as OCV₁ (Open Circuit Voltage). Where, the voltage upon electrochemical equilibrium obtained after the battery has rested is the voltage after eliminating the concentration polarization generated by the battery in the charging process.

At S130, collect the second voltage of the to-be-tested battery.

After the first voltage of the to-be-tested battery upon completion of electrochemical equilibrium has been obtained, the second voltage of the to-be-tested battery is collected and labeled as OCV₂.

At S140: determine that lithium plating has occurred in the to-be-tested battery in case where the difference between the second voltage and the first voltage is greater than the first voltage threshold.

Please refer again to FIG. 3. For the battery with lithium plating, its full battery voltage increases gradually during the rest period, and it may be determined that lithium plating has occurred in the to-be-tested battery in case where the full battery voltage increases to exceed OCV₁ of the to-be-tested battery, which is the voltage upon completion of electrochemical equilibrium, by a certain value. Therefore, it is possible to determine whether lithium plating has occurred in the to-be-tested battery by determining whether a difference between the collected OCV₂ and OCV₁ is greater than the first voltage threshold.

The first voltage threshold may range from 5~30 millivolts (mV).

The value range 5 to 30mV of the first voltage threshold is set according to the voltage acquisition accuracy of the BMS, which may match the voltage acquisition accuracy of the BMS to avoid incorrect determination that lithium plating has occurred in to-be-tested battery.

In some embodiments, the first voltage threshold may be 5mV, that is, in case where (OCV₂-OCV₁) > 5mV, it is determined that lithium plating has occurred in the to-be-tested battery. Given that most BMS have a voltage acquisition accuracy of about 5mV, it is usually required to set the first voltage threshold to be at least 5mV. The voltage sampling accuracy of 5mV indicates that the voltage collected during the sampling fluctuates within a range (of accurately ±5mV). The value (OCV₂-OCV₁) within 5mV may be due to the fluctuation caused by the detection error, rather than the existence of lithium plating in the battery. If the first voltage threshold is set to be less than 5mV, it will lead to an incorrect determination that lithium plating has occurred in the to-be-tested battery. By setting the first voltage threshold to be 5mV, not only the voltage acquisition accuracy of the BMS can be matched, so as to avoid the incorrect determination that lithium plating has occurred in the to-be-tested battery, but also detection requirements for most batteries may be satisfied, and the applicability is improved.

It is understood that the first voltage threshold may also be 10m V, 15mV, 20mV or 30mV according to the voltage acquisition accuracy of the battery BMS applying the battery lithium plating detection method of the embodiments of this disclosure.

The embodiments of this disclosure obtain the first voltage of the battery upon completion of electrochemical equilibrium by first charging the battery to the specific SOC and allowing the battery to rest. Then, the second voltage of the battery is collected. In case where the difference between the second voltage and the first voltage is greater than the first voltage threshold value, it can be determined that lithium plating has occurred in the battery. The detection has high efficiency, and may avoid long-time lithium plating from forming lithium dendrite to piece the separator and result in short circuit and thermal runaway of the battery, and improve battery safety.

In addition, the battery lithium plating detection method of the embodiments of this application may be realized when the BMS system of the battery starts and normally performs voltage collection.

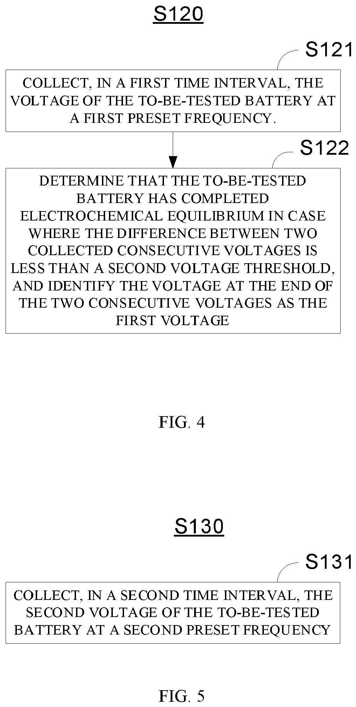

FIG. 4 is a flow chart for illustrating the S 120 in FIG. 1. As shown in FIG. 4, in some embodiments S 120 includes:
At S 121, collect, in the first time interval, the voltage of the to-be-tested battery at a first preset frequency.

The battery will complete the electrochemical equilibrium in a short period after the battery is stopped charging and allowed to rest. Therefore, it is possible to set a relatively narrow first time interval, in which, the voltage of the to-be-tested battery is collected at the first preset frequency.

The first time interval may be set to be 0-20min. In general, the to-be-tested battery will complete the electrochemical equilibrium in a few minutes. Therefore, the value of the first time interval needs not be too large. In case where the first time interval is 0, that is, it is unnecessary to set the time interval, the voltage of the to-be-tested battery may be directly collected at the first preset frequency after the battery has been charged to the first SOC and allowed to rest.

The first preset frequency may be set as 1/second (s) to realize a timely detection in case where system performance supports.

At S 122: determine that the to-be-tested battery has completed electrochemical equilibrium in case where the difference between two collected consecutive voltages is less than a second voltage threshold, and identify the voltage at the end of the two consecutive voltages as the first voltage.

As set before, in the process of mutual conversion of chemical energy and electric energy of a battery, the reaction reaches equilibrium when the total rate of the reaction V = V _{forward} - V _{backward} =0, that is, the battery has completed the electrochemical equilibrium. Therefore, when there is almost no difference or small difference between the collected two consecutive voltages, the battery has completed the electrochemical equilibrium. S 122 may determine whether the to-be-tested battery has completed the electrochemical equilibrium by determining whether the difference between the collected two consecutive voltages is less than the second voltage threshold. In case where the difference between the collected two consecutive voltages is less than the second voltage threshold, it is determined that the to-be-tested battery has completed the electrochemical equilibrium. At this point, identify the voltage at the end of the two consecutive voltages as OCV₁.

The second voltage threshold may range from 1∼5mV. For example, the second voltage threshold is 5mV.

By setting the range of the second voltage threshold as 1∼5mV, it is possible to make a relatively accurate determination on whether the to-be-tested battery has completed the electrochemical equilibrium. Further, due to the voltage acquisition accuracy of the BMS of about 5mV, the voltage fluctuation of the battery after the completion of electrochemical equilibrium is basically within 5mV. By setting the second voltage threshold as 5mV, not only the voltage acquisition accuracy of the BMS may be matched, so as to avoid incorrect determination that lithium plating has occurred in the to-be-tested battery, but also detection requirements for most batteries may be satisfied, and the applicability is improved.

By collecting the voltage of the to-be-tested battery in the first time interval, determining that the to-be-tested battery has completed the electrochemical equilibrium in case where the difference between two collected consecutive voltages is less than the second voltage threshold, and thereby identifying the first voltage, the embodiments of this disclosure may make a relatively accurate determination that the to-be-tested battery has completed the electrochemical equilibrium, so as to improve the accuracy of the obtained first voltage. By collecting the voltage of the to-be-tested battery at the first preset frequency, the detection of the first voltage may be made more timely.

FIG. 5 is a flow chart for illustrating the S130 in FIG. 1. As shown in FIG. 5, in some embodiments S130 includes:
At S131, collect, in a second time interval, the second voltage of the to-be-tested battery at a second preset frequency.

In case where lithium plating has occurred in a battery, the full battery voltage of the to-be-tested battery will increase to exceed OCV1 of the to-be-tested battery, which is the voltage upon completion of electrochemical equilibrium, by a certain value after a period of time. It is possible to set a second time interval, in which, the second voltage of the to-be-tested battery may be collected at the second preset frequency for determination of the voltage difference in S 140. The second time interval may be greater than or equal to a certain threshold. For a battery with lithium plating, it is possible that the difference between the second voltage collected in the second time interval and the first voltage is greater than the first voltage threshold, and it may be determined that lithium plating has occurred in the to-be-tested battery. This may improve the accuracy of the detection results, and avoid failing to detect lithium plating. By collecting the second voltage of the to-be-tested battery at the second preset frequency, the detection of lithium plating may be made more timely.

In some embodiments, the second time interval may be greater than or equal to 5min. Generally, when rested for about 5min after the completion of electrochemical equilibrium, the to-be-tested battery the whole battery will has its full battery voltage significantly increased. By setting the second time interval to be greater than or equal to 5min, it may be certain that for a battery with lithium plating, the OCV₂ has shown a relatively obvious rebound compared with the OCV₁, that is, the difference between the OCV₂ and the OCV₁ will be greater than the set first voltage threshold at this time. Even for a battery with lithium plating, if the second time interval is less than 5min, the OCV₂ may not have shown a relatively obvious rebound over the OCV₁ in this time interval, and the difference between the OCV₂ and OCV₁ collected in this time interval may not be greater than the first voltage threshold, therefore no result will indicate that lithium plating has occurred in the to-be-tested battery and the determination result is incorrect. Therefore, by setting the second time interval to be greater than or equal to 5min, not only the accuracy of the detection results may be improved, so as to avoid failing to detect lithium plating, but also the detection requirements for most batteries may be satisfied, and the applicability may be improved.

The second preset frequency may be set to 1/s to realize a timely detection in case where system performance supports.

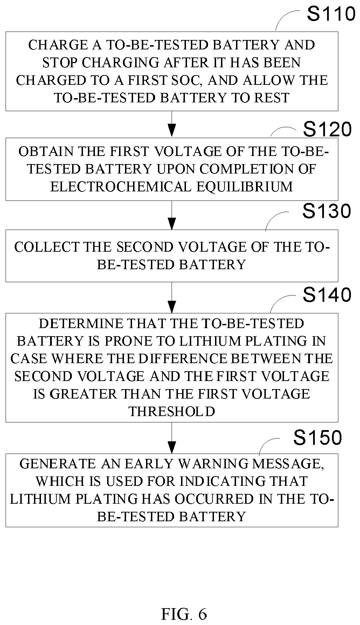

FIG. 6 is a schematic flow chart of a battery lithium plating detection method provided in some embodiments of this disclosure. As shown in FIG. 6, after S 140, the method also includes:
At S150, generate an early warning message, which is used for indicating that lithium plating has occurred in the to-be-tested battery.

The early warning message may be a text message, a voice message, or a light message, etc., or may be any combination of the above messages. For example, a text warning message may be displayed on a display screen to indicate lithium plating, or the text warning message may be sent by pushing a short message to indicate lithium plating, or a sound and light alarm may be used to indicate lithium plating.

After determining that lithium plating has occurred in the to-be-tested battery, the warning message is prompted to indicate the existence of lithium plating in the to-be-tested battery, so that the operator may process correspondingly. This further avoids long-time lithium plating from forming lithium dendrite to piece the separator and result in battery short circuit and thermal control, and further improves the battery safety.

The operator may choose to unplug the charging gun to stop charging, and perform corresponding security risk treatment on the battery.

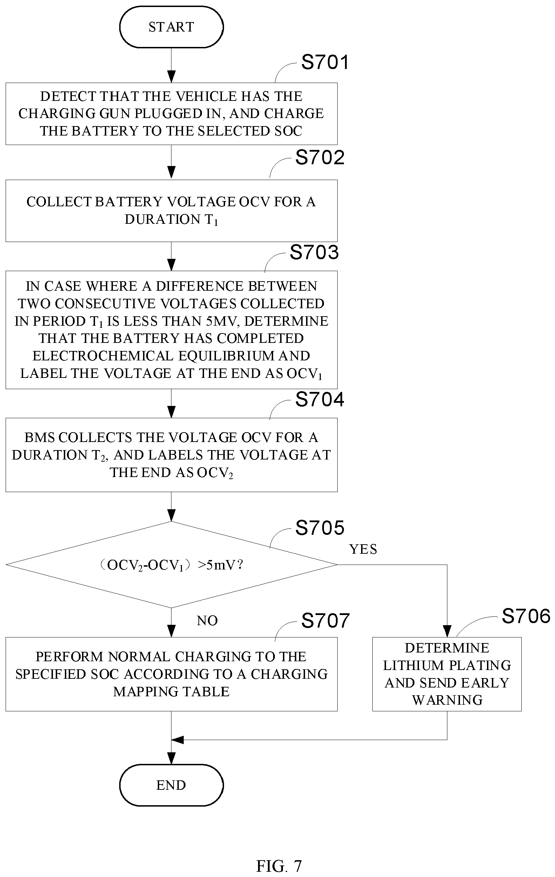

FIG. 7 is a schematic flow chart of lithium battery lithium plating detection method for electric vehicles provided in some embodiments of this disclosure. As shown in FIG. 7, the method includes:
At S701, the BMS detects that the vehicle has the charging gun plugged in, and charges the battery to the selected SOC.

Where, the SOC may be selected from 5%~30%, 50%-60%.

At S702, the BMS collects battery voltage OCV for a duration T₁.

T₁ ranges from 0~20min.

At S703: in case where a difference between two consecutive voltages collected in period T₁ is less than 5mV, determine that the battery has completed electrochemical equilibrium and label the voltage at the end as OCV₁.

At S704, the BMS collects the voltage OCV for a duration T₂, and labels the voltage at the end as OCV₂.

T₂ ranges from 0 ~100min.

At S705, the BMS determines whether (OCV₂-OCV₁) is greater than SmV; and if so, executes S706, or executes S707.

At S706, the BMS determines lithium plating and sends early warning.

The BMS may send an early warning message to the vehicle or the vehicle terminal for early warning.

At S707, the BMS performs normal charging to the specified SOC according to a charging mapping table.

After the early warning for lithium plating, the charging gun may be unplugged to end this detection. The charging gun also needs to be unplugged to end the charging when the specified SOC is reached during normal charging.

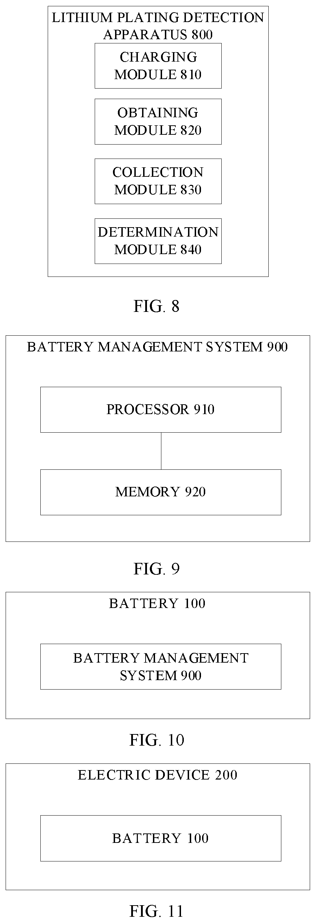

The battery lithium plating detection method of the embodiments of this disclosure has been described above with reference to FIG. 1 to FIG. 7. A battery lithium plating detection device of the embodiments of this disclosure is described below with reference to FIG. 8. For the parts not described in detail, the above-mentioned embodiments may be referred to. FIG. 8 is a schematic structural diagram of a battery lithium plating detection device provided in some embodiments of this disclosure. As shown in FIG. 8, the battery lithium plating detection device 800 includes: a charging module 810, an obtaining module 820, a collection module 830 and a determination module 840. Among them:
The charging module 810 is used for charging a to-be-tested battery and stopping charge after the battery is charged to a first state of charge (SOC), and allowing the to-be-tested battery to rest;
The obtaining module 820 is used for obtaining a first voltage of the to-be-tested battery upon completion of electrochemical equilibrium;
The collection module 830 is used for collecting a second voltage of the to-be-tested battery;
The determination module 840 is used for determining that lithium plating has occurred in the to-be-tested battery in case where a difference between the second voltage and the first voltage is greater than a first voltage threshold.

The embodiments of this disclosure obtain the first voltage of the battery upon completion of electrochemical equilibrium by first charging the battery to the specific SOC and allowing the battery to rest. Then, the second voltage of the battery is collected. In case where the difference between the second voltage and the first voltage is greater than the first voltage threshold value, it can be determined that lithium plating has occurred in the battery. The detection has high efficiency, and may avoid long-time lithium plating from forming lithium dendrite to piece the separator and result in short circuit and thermal runaway of the battery, and improve battery safety.

A battery management system of the embodiments of this disclosure is described below with reference to FIG. 9. For the parts not described in detail, the above-mentioned embodiments may be referred to. FIG. 9 is a schematic structural diagram of a battery management system provided in some embodiments of this disclosure. As shown in FIG. 9, the battery management system 900 includes: at least one processor 910; and a memory 920 communicatively connected with the at least one processor 910; where, the memory 920 stores instructions executable by the at least one processor 910, and the instructions are executed by the at least one processor 910 to enable the battery management system 900 to implement the steps of the battery lithium plating detection method in the above embodiments.

A battery of the embodiments of this disclosure is described below with reference to FIG. 10. For the parts not described in detail, the above-mentioned embodiments may be referred to. FIG. 10 is a schematic structural diagram of a battery provided in some embodiments of this disclosure. As shown in FIG. 10, the battery 100 includes the battery management system 900 as shown in FIG. 9.

An electric device of the embodiments of this disclosure is described below with reference to FIG. 11. For the parts not described in detail, the above-mentioned embodiments may be referred to. FIG. 11 is a schematic structural diagram of an electric device provided in some embodiments of this disclosure. As shown in FIG. 11, the electric device 200 includes the battery 100 as shown in FIG. 10.

Finally, it should be noted that, the above embodiments are merely intended for describing but not for limiting the technical solutions of the present disclosure. Although the present disclosure is described in detail with reference to the above-mentioned embodiments, it should be understood by those skilled in the art that, the technical solutions recited in each of the above-mentioned embodiments may still be modified, or some of or all the technical features may be equivalently replaced, while these modifications or replacements do not make the essence of the corresponding technical solutions depart from the scope of the technical solutions of each of the embodiments of the present disclosure, and should be included within the scope of the claims and specification of the present disclosure. In particular, each of the technical features referred to in the various embodiments may be combined in any manner, provided that there is no structural conflict. This disclosure is not limited to the specific embodiments disclosed herein, but covers all technical solutions falling within the scope of the claims.

## Claims

1. A lithium plating detection method, comprising:
charging a to-be-tested battery and stopping charging after the to-be-tested battery has been charged to a first state of charge (SOC), and allowing the to-be-tested battery to rest;
obtaining a first voltage of the to-be-tested battery upon completion of electrochemical equilibrium;
collecting a second voltage of the to-be-tested battery; and
determining that lithium plating has occurred in the to-be-tested battery in case where a difference between the second voltage and the first voltage is greater than a first voltage threshold.

2. The method according to claim 1, wherein the first SOC meets a first SOC range or a second SOC threshold range, wherein the first SOC threshold range is 5%-30% and the second SOC threshold range is 50%-60%.

3. The method according to claim 1 or 2, wherein the first voltage threshold ranges from 5~30 millivolts (mV).

4. The method according to claim 3, wherein the first voltage threshold is 5mV.

5. The method according to any one of claims 1-4, wherein said obtaining a first voltage of the to-be-tested battery upon completion of electrochemical equilibrium comprises:
collecting, in a first time interval, voltage of the to-be-tested battery at a first preset frequency; and
determining that the to-be-tested battery has completed electrochemical equilibrium in case where a difference between two collected consecutive voltages is less than a second voltage threshold, and identifying a voltage at end of the two consecutive voltages as the first voltage.

6. The method according to claim 5, wherein the second voltage threshold ranges from 1~5mV.

7. The method according to claim 6, wherein the second voltage threshold is 5mV.

8. The method according to any one of claims 1-7, wherein said collecting a second voltage of the to-be-tested battery comprises:
collecting, in a second time interval, the second voltage of the to-be-tested battery at a second preset frequency.

9. The method according to claim 8, wherein the second time interval is greater than 5min.

10. The method according to any one of claims 1-9, wherein after said determining that lithium plating has occurred in the to-be-tested battery in case where a difference between the second voltage and the first voltage is greater than a first voltage threshold, the method further comprises:
generating an early warning message, which is used for indicating that lithium plating has occurred in the to-be-tested battery.

11. A battery lithium plating detection device, comprising:
a charging module for charging a to-be-tested battery and stopping charging after the to-be-tested battery has been charged to a first state of charge (SOC), and allowing the to-be-tested battery to rest;
an obtaining module for obtaining a first voltage of the to-be-tested battery upon completion of electrochemical equilibrium;
a collection module for collecting a second voltage of the to-be-tested battery; and
a determination module for determining that lithium plating has occurred in the to-be-tested battery in case where a difference between the second voltage and the first voltage is greater than a first voltage threshold.

12. A battery management system, comprising:
at least one processor; and
a memory communicatively connected with the at least one processor;
wherein the memory stores instructions executable by the at least one processor, and the instructions are executed by the at least one processor to enable the battery management system to implement steps of the battery lithium plating detection method according to any one of claims 1-10.

13. A battery comprising the battery management system according to claim 12.

14. An electric device comprising the battery according to claim 13, wherein the battery is for supplying electric energy.
